## Europäisches Patentamt
## European Patent Office
## Office européen des brevets

(19)

(11) Veröffentlichungsnummer: **0 177 798**
**B1**

(12)

# EUROPÄISCHE PATENTSCHRIFT

(45) Veröffentlichungstag der Patentschrift:
**04.01.89**

(51) Int. Cl.⁴: **H 01 F 7/00,** H 01 H 50/04

(21) Anmeldenummer: **85111585.7**

(22) Anmeldetag: **13.09.85**

(54) **An einer Platine lösbar befestigbarer Elektromagnet.**

(30) Priorität: **09.10.84 DE 3437002**

(43) Veröffentlichungstag der Anmeldung:
**16.04.86 Patentblatt 86/16**

(45) Bekanntmachung des Hinweises auf die Patenterteilung:
**04.01.89 Patentblatt 89/1**

(84) Benannte Vertragsstaaten:
**DE FR GB IT**

(56) Entgegenhaltungen:
**DE-A-3 112 294**
**DE-B-2 630 955**
**FR-A-2 208 174**
**FR-A-2 491 253**

(73) Patentinhaber: **Mannesmann Kienzle GmbH, Heinrich- Hertz- Strasse, D-7730 Villingen-Schwenningen (DE)**

(72) Erfinder: **Hauger, Josef, Pforzheimer Strasse 31, D-7730 Villingen- Schwenningen (DE)**
Erfinder: **Schlassus, Wolfgang, Rietheimer Strasse 16, D-7730 Villingen- Schwenningen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 177 798 B1

## Beschreibung

Die Erfindung betrifft einen an einer Platine lösbar befestigbaren Elektromagneten mit U-förmig profiliertem Magnetjoch.

In der Feinwerktechnik sind durch Nutzung der hochentwickelten Kunststoff-Spritzgußtechnik für die Herstellung der einzelnen, in einem Gerät zusammenwirkenden Bauelemente und Baugruppen bekanntlich beachtliche Rationalisierungseffekte erzielbar. Voraussetzung hierfür ist jedoch eine auf Mehrfachfunktionalität ausgerichtete, konstruktive Gestaltung der Bauelemente sowie eine Gestaltung, die aufwendige Montagearbeitsgänge, insbesondere Ausricht- und Justierarbeitsgänge vereinfacht oder unnötig macht und die die Anwendung von Verschraubungen sowie Niet- und Klebeverbindungen weitgehend vermeidet.

Einen entwicklungs- und fertigungstechnischen Höhepunkt stellt in dieser Hinsicht die sog. Outsert-Technik dar, bei der eine Vielzahl unterschiedlicher Funktionselemente aus Kunststoff in einem einzigen Arbeitsgang durch Spritzgießen gefertigt und mit einer tragenden, vorzugsweise metallischen, Platine, die hohe Maßhaltigkeit garantiert, verbunden, d.h. an der Platine angeschrumpft werden.

Diese Technik des Angießens oder Einbettens ist jedoch nicht in allen Fällen anwendbar, insbesondere dann nicht, wenn das betreffende Bauelement ein relativ kurzlebiges Verschleißteil darstellt, somit also austauschbar sein muß, wenn das Bauelement nur in einem bestimmten Gerätetyp oder auf Kundenwunsch erforderlich ist oder wenn es sich um ein Bauelement oder eine Baugruppe handelt, die aufgrund ihrer Architektur und/oder mangelnder Wärmefestigkeit spritzgußtechnisch nicht befestigbar ist. In solchen Fällen müssen, will man Schraub- oder Klebeverbindungen vermeiden, Rast- und Schnappverbindungen angewandt und das Risiko in Kauf genommen werden, daß bei ungeeigneter konstruktiver Gestaltung die angeformten Riegel oder Rastelemente, insbesondere bei mehrfacher Betätigung brechen oder im Laufe der Zeit Ermüdungserscheinungen zeigen.

Bezüglich einiger Bauelemente und Baugruppen, insbesondere solcher mit größeren Massen und solche, bei denen aufgrund ihrer Funktion von den Befestigungsmitteln Kräfte aufgenommen werden müssen, oder auch weil es sich um quasi normierte, handelsübliche Bauelemente handelt, standen daher die teuren, klassischen Befestigungsmethoden bisher nicht in Frage, d.h es wurde auf eine moderne Montagetechnik verzichtet.

In dieser Hinsicht typische Bauelemente sind beispielsweise Elektromagnete. Sie wurden bisher in aufwendiger Weise, bevorzugt jedoch durch Verschrauben oder auch unter Verwendung spezieller Klammern mit dem tragenden Bauteil, vorzugsweise einer Platine, verbunden.

Aufgabe der vorliegenden Erfindung war es daher, den Montageaufwand für einen im allgemeinen mit einem U-förmig profilierten Magnetjoch versehenen Elektromagneten unter Beibehaltung einer befriedigenden Lagefixierung zu verringern und die Voraussetzung für eine maschinelle Montage zu schaffen.

Die Lösung dieser Aufgabe sieht vor, daß in der Platine den Schenkeln des Magnetjoches zugeordnete Durchbrüche ausgebildet sind, daß die Schenkel und die Durchbrüche derart durch Einschnitte und Vorsprünge konturiert sind, daß der Elektromagnet mittels einer Renkbewegung formschlüssig mit der Platine verbindbar ist und daß an der Platine eine senkrecht zur Platinenebene federungsfähige und in einen der Durchbrüche hineinragende Zunge ausgebildet ist, welche, wenn der Elektromagnet und die Platine formschlüssig miteinander verbunden sind, stirnseitig an einem Schenkel des Magnetjoches anliegt.

Eine in der Praxis vorteilhafte Ausbildungsform ist dadurch gekennzeichnet, daß an der Zunge stirnseitig eine zur Platinenebene geneigte Keilfläche ausgebildet ist und daß die Keilfläche mit einer Kante eines Schenkels des Magnetjoches zusammenwirkt.

Abgesehen davon, daß die gefundene konstruktive Gestaltung die gestellte Aufgabe zufriedenstellend löst, bietet sie zusätzlich den Vorteil, einen Elektromagneten werkzeuglos und mit einer Hand mit einer Platine verbinden zu können. Ferner stellt die gewählte formschlüssige Verbindung im Zusammenwirken mit der für den Toleranzausgleich in geeigneter Weise in der Platinenebene ausgebildeten Zunge eine für die Befestigung eines Elektromagneten in besonderer Weise optimierte, starre Verbindung dar. Dabei ist, ohne daß ein nennenswerter, zusätzlicher Raumbedarf entsteht, die Bauform des Magnetjoches für die Realisierung der Erfindung durch lediglich Verlängern bzw. Verbreitern der Jochschenkel vorteilhaft genutzt. Erwähnenswert ist ferner, daß der formtechnische Aufwand seitens der Platine vernachlässigbar gering ist und daß nur ein federndes Element erforderlich ist, das, weil es in der Platinenebene ausgebildet ist, weitgehend geschützt ist.

Im folgenden sei die Erfindung anhand der beigefügten Zeichnungen näher erläutert. Es zeigen:

FIG. 1    eine perspektivische Darstellung eines erfindungsgemäß ausgebildeten Elektromagneten und einer diesem zugeordneten Platine vor deren Zusammenbau,

FIG. 2    eine perspektivische Darstellung des Elektromagneten und der Platine gemäß FIG. 1 nach deren Zusammenbau,

FIG. 3    ein Schnittbild lediglich des Magnetjoches und der Platine in einer Funktionsstellung während des Zusammenfügens,

FIG. 4 eine vergrößerte Darstellung der Einzelheit A in FIG. 3 nach dem Zusammenfügen von Magnetjoch und Platine,

FIG. 5 eine perspektivische Darstellung eines weiteren Ausführungsbeispieles des Elektromagneten bzw. dessen Magnetjoches und der zugeordneten, entsprechend ausgeformten Platine,

FIG. 6 eine weitere, dem Spielausgleich senkrecht zur Platinenebene dienende Variante des Ausführungsbeispieles gemäß FIG. 5.

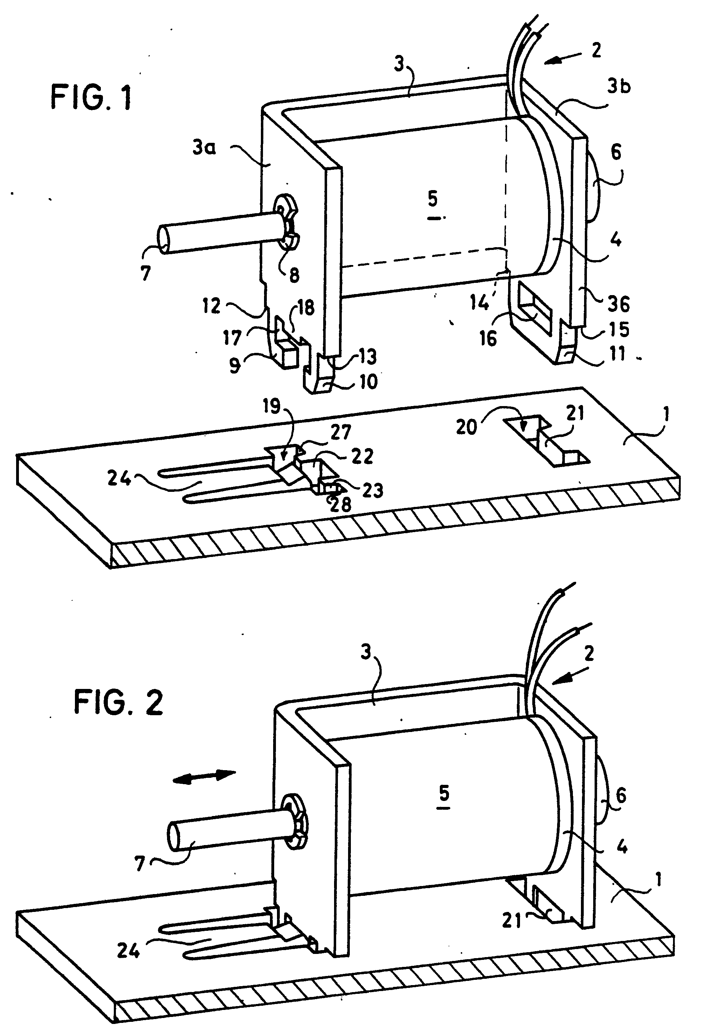

Wie aus FIG. 1 ersichtlich ist, besteht der gewählte und an einer Platine 1 zu befestigende, als Tauchankermagnet ausgebildete Elektromagnet 2 aus einem U-förmig geformten Magnetjoch 3, einem Spulenkörper 4, einer Wicklung 5 und einem Tauchanker 6, mit welchem in an sich bekannter Weise eine Schaltstange 7 verbunden ist. Eine auf der Schaltstange 7 angeordnete Sicherungsscheibe 8 dient im Zusammenwirken mit einer nicht dargestellten Rückzugsfeder und der Außenwand des Schenkels 3a des Magnetjoches 3 als Anschlag in der Ruheposition des Elektromagneten 2, während für die Übertragung der Schaltbewegung des Elektromagneten 2 auf ein anzutreibendes Organ, beispielsweise ein geeignetes, ebenfalls auf der Schaltstange 7 anzuordnendes, jedoch, weil nicht erfindungswesentlich, nicht dargestelltes Kupplungselement vorgesehen sein kann.

Die FIG. 1 zeigt ferner daß an den Schenkeln 3a und 3b des Magnetjoches 3 stirnseitig Fortsätze 9, 10 und 11 angeformt sind, und zwar vorzugsweise derart radialsymmetrisch zur Achse des Elektromagneten 2, daß sich an den Schenkeln 3a und 3b jeweils beiderseits der Fortsätze 9, 10 und 11 in ein und derselben Ebene liegende Schulterflächen 12, 13, 14 und 15 ergeben. Außerdem ist ersichtlich, daß in dem Fortsatz 11 des Schenkels 3b ein Schlitz 16 ausgeformt ist, während die hakenartigen Fortsätze 9 und 10 des Schenkels 3a eine Freisparung 17 umschließen, in die ein aus der Ebene, in der die Schulterflächen 12, 13, 14 und 15 liegen, heraustretender Schenkelansatz 18 hineinragt.

Den Fortsätzen 9, 10 und 11 sind in der Platine 1 Durchbrüche 19 und 20 zugeordnet. Dabei ragt in den einen Durchbruch 20 ein Vorsprung 21, während in den anderen Durchbruch 19 jeweils dem Fortsatz 9 bzw. 10 zugeordnete Vorsprünge 22 und 23 sowie eine federnde, in der Ebene der Platine 1 liegende Zunge 24 hineinragen.

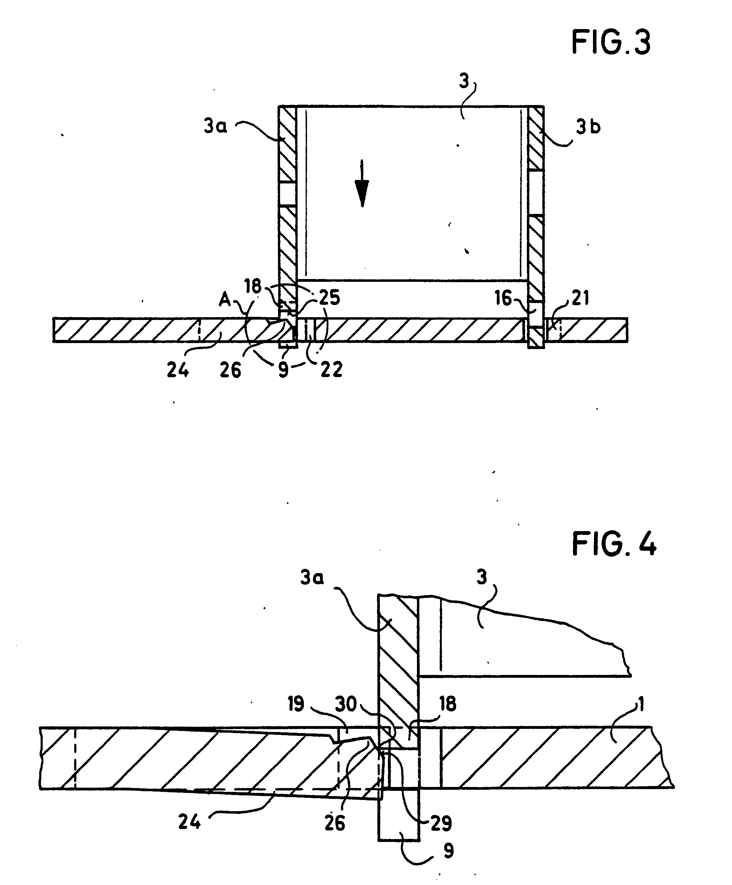

Werden beim Befestigen des Elektromagneten 2 die Fortsätze 9 und 10 bzw. 11 in die betreffenden Durchbrüche 19 bzw. 20 in der Platine 1 eingeführt und der Elektromagnet 2 in Pfeilrichtung gegen die Platine 1 bewegt, so wird gemäß FIG. 3, in der der Einfachheit halber lediglich das Magnetjoch 3 dargestellt ist, die Stirnfläche 25 des Schenkelansatzes 18 mit einer an der Zunge 24 ausgebildeten Kante 26 in Berührung kommen und die Zunge 24 solange verschwenkt werden, bis die Schulterflächen 12, 13, 14 und 15 an der Platine 1 anliegen. Danach bzw. kurz zuvor ist ein Verschieben des Elektromagneten 2 in Richtung der Platinenebene möglich, wodurch der Schlitz 16 und der Vorsprung 21 sowie die Fortsätze 9 und 10 und die Vorsprünge 22 und 23 in Eingriff kommen und somit die angestrebte, formschlüssige Verbindung zwischen der Platine 1 und dem Elektromagneten 2 erfolgt. Liegen, was aus FIG. 4 ersichtlich ist, die Fortsätze 9 und 10 an den Flächen 27 und 28 des Durchbruches 19 an, so ist die Zunge 24 bis zur Anlage einer an ihr angeformten Keilfläche 29 an der Kante 30 des Schenkelansatzes 18 zurückgefedert und sperrt ein Zurückschieben des Elektromagneten 2. Mit dieser Anordnung ist außerdem ein spielfreies Festhalten des Elektromagneten 2 auch bei Maßschwankungen des Jochbleches gewährleistet.

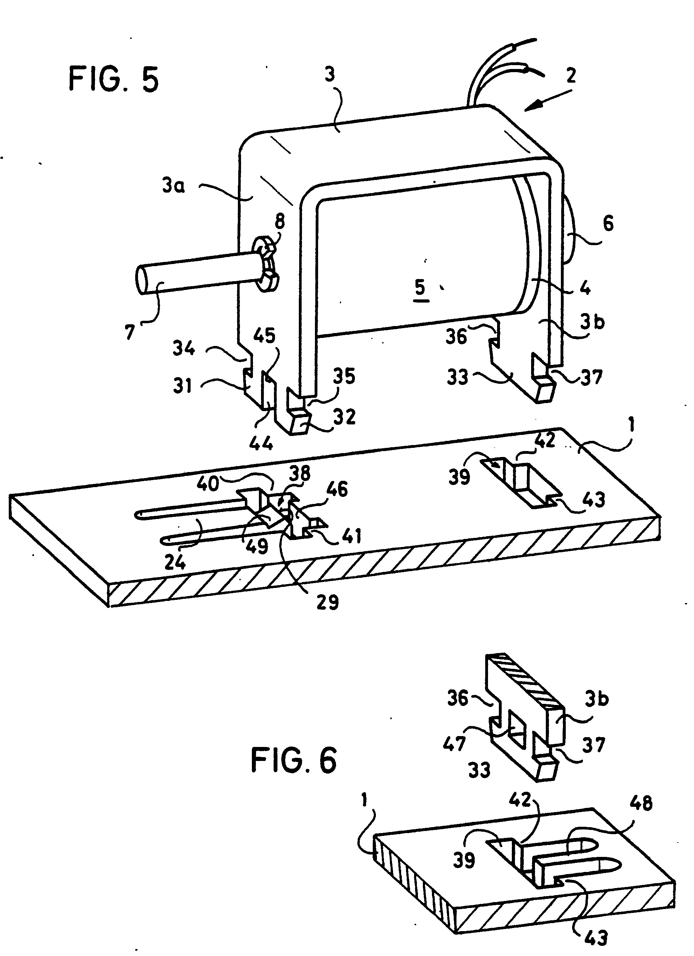

Beim Ausführungsbeispiel gemäß FIG. 5 sind die Fortsätze 31, 32 und 33 im Gegensatz zum bisher beschriebenen Ausführungsbeispiel nicht quer sondern in Richtung der Schenkel 3a und 3b des Magnetjoches 3 ausgebildet und entgegengesetzt konturiert, d.h. es sind nach außen weisende, der Platinenstärke entsprechende Schlitze 34, 35, 36 und 37 ausgebildet. Die in der Platine 1 ausgeformten Durchbrüche 38 und 39 weisen, um die formschlüssige Verbindung zwischen den Schenkeln 3a und 3b des Magnetjoches 3 und der Platine 1 zu ermöglichen, den Schlitzen 34, 35, 36 und 37 zugeordnete Rampen 40, 41, 42 und 43 auf. Entscheidend ist, daß, wie in dem zuvor beschriebenen Ausführungsbeispiel, die nicht bezeichnete Grundfläche des zwischen den Fortsätzen 31 und 32 vorgesehenen Schlitzes 44 nicht mit der Auflageebene der Schenkel 3a und 3b zusammenfällt, sondern daß die Kante 45, wenn der Elektromagnet 2 mit der Platine 1 verbunden ist, sich innerhalb des Durchbruches 38 befindet und, wie im zuvor beschriebenen Ausführungsbeispiel, mit der Keilfläche 29 der Zunge 24 zusammenwirkt. Dabei dient die Fläche 46 den Fortsätzen 31 und 32 und somit dem Magnetjoch 3 als Anlagefläche.

In FIG. 6 ist das Ausführungsbeispiel gemäß FIG. 5 dadurch erweitert, daß in dem Fortsatz 33 eine Öffnung 47 ausgebildet ist und daß in der Platine 1 eine ebenfalls senkrecht zur Platinenebene federungsfähige Zunge 48 ausgeformt ist, und zwar derart, daß die Zunge 48 die vom Elektromagneten 2 abgewandte Platinenseite um ein geringes Maß überragt.

Die Zunge 48 ist der Öffnung 47 zugeordnet, d.h. im montierten Zustand des Elektromagneten 2 steht die Zunge 48 unter einer gewissen Vorspannung und dient sozusagen als Niederhalter, um evtl. vorhandenes, toleranzbedingtes Spiel auszugleichen.

Der Vollständigkeit halber sei noch erwähnt, daß, um eine möglichst geringe Durchbiegung und somit eine Überdehnung der Zunge 24 beim Aufsetzen des Elektromagneten 2 zu erreichen, die Zunge 24 mit einer Kerbe 49 versehen ist, daß bezüglich des Magnetjoches 3 die Stanzrichtung so gewählt werden sollte, daß die Kanten 30 und 45 eingezogen sind und daß die Anordnung der Zunge 24 auch zwischen den Schenkeln 3a und 3b des Magnetjoches 3 vorgesehen sein kann.

### Patentansprüche

1. An einer Platine (1) lösbar befestigbarer Elektromagnet (2) mit U-förmig profiliertem Magnetjoch (3),
dadurch gekennzeichnet,
daß in der Platine (1) den Schenkeln (3a, 3b) des Magnetjoches (3) zugeordnete Durchbrüche (19, 20 bzw. 38, 39) ausgebildet sind,
daß die Schenkel (3a, 3b) und die Durchbrüche (19, 20 bzw. 38, 39) derart durch Einschnitte (16, 17 bzw. 34, 35, 36, 37) und Vorsprünge (9, 10, 21, 22, 23 bzw. 40, 41, 42, 43) konturiert sind, daß der Elektromagnet (2) mittels einer Renkbewegung formschlüssig mit der Platine (1) verbindbar ist und
daß an der Platine (1) eine senkrecht zur Platinenebene federungsfähige und in einen der Durchbrüche (19; 38) hineinragende Zunge (24) ausgebildet ist, welche, wenn der Elektromagnet (2) und die Platine (1) formschlüssig miteinander verbunden sind, stirnseitig an einem Schenkel (3a) des Magnetjoches (3) anliegt.

2. An einer Platine lösbar befestigbarer Elektromagnet nach Anspruch 1,
dadurch gekennzeichnet,
daß an der Zunge (24) stirnseitig eine zur Platinenebene geneigte Keilfläche (29) ausgebildet ist und daß die Keilfläche (29) mit einer Kante (30 bzw. 45) des Schenkels (3a) des Magnetjoches (3) zusammenwirkt.

3. An einer Platine lösbar befestigbarer Elektromagnet nach Anspruch 1,
dadurch gekennzeichnet,
daß eine weitere senkrecht zur Platinenebene federungsfähige Zunge (48) ausgebildet ist,
daß der Zunge (48) in dem einen Schenkel (36) des Magnetjoches (3) eine Öffnung (47) zugeordnet ist und daß die Zunge (48) um ein geringes Maß die Platine (1) überragt.

### Claims

1. Electromagnet (2) with a U-shaped magnet yoke (3) which can be releasably attached to a plate (1), characterised in that openings (19, 20 or 38, 39) associated with the sides (3a, 3b) of the magnet yoke (3) are formed in the plate (1), that the sides (3a, 3b) and the openings (19, 20 or 38, 39) are so contoured by recesses (16, 17 or 34, 35, 36, 37) and projections (9, 10, 21, 22, 23 or 40, 41, 42, 43) that the electromagnet (2) can be connected positively to the plate (1) by means of a bayonet movement and that a tongue (24) which is able to be resilient perpendicular to the plane of the plate and projects into one of the openings (19; 38) is provided on the plate (1), which tongue, when the electromagnet (2) and the plate (1) are connected positively to each other, bears by its end face against one side (3a) of the magnet yoke (3).

2. Electromagnet able to be releasably attached to a plate, according to claim 1, characterised in that a wedge surface (29) inclined with respect to the plane of the plate is provided on the end face of the tongue (24) and that the wedge surface (29) co-operates with an edge (30) or (45) of the side (3a) of the magnet yoke (3).

3. Electromagnet able to be releasably attached to a plate, according to claim 1, characterised in that a further tongue (48) able to be resilient perpendicular to the plane of the plate is provided, that in one side (36) of the magnet yoke (3) an opening (47) is associated with the tongue (48) and that the tongue (48) projects beyond the plate (1) by a small amount.

### Revendications

1. Electro-aimant (2) avec une culasse magnétique profilée en forme de U fixé, de manière amovible, sur une platine,
caractérisé par le fait,
que, dans la platine (1), sont formés des percements (19, 20 ou 38, 39) associés aux branches (3a, 3b) de la culasse magnétique (3),
que les branches (3a, 3b) et les percements (19, 20 ou 38, 39) sont réalisés, par des évidements (16, 17 ou 34, 35, 36, 37) et des saillies (9, 10, 21, 22, 23 ou 40, 41, 42, 43), avec des contours tels que l'électro-aimant (2) puisse être fonctionnellement assemblé avec la platine (1) par un mouvement unidirectionnel et que sur la platine (1) est formée une languette (24) élastique perpendiculairement au plan de la platine et pénétrant dans l'un des percements (19; 38) laquelle appuie, lorsque l'électro-aimant (2) et la platine (1) sont fonctionnellement assemblées, avec sa face frontale, l'une des branches (3a) de la culasse magnetique (3).

2. Electro-aimant fixé, de manière amovible, sur une platine conformément à la revendication 1,
caractérisée par le fait
que sur la face frontale de la languette (24) est formée une surface cunéiforme (29) inclinée par rapport au plan de platine et
que ladite surface cunéiforme (29) coopère avec un bord (30 ou 45) d'une branche (3a) de la culasse magnétique (3).

3. Electro-aimant fixé, de manière amovible, sur une platine conformément à la revendication 1,
caractérisé par le fait
qu'une autre languette (48) élastique perpendiculairement

au plan de platine a été réalisée,
qu'à ladite languette (48) est associé un orifice (47) dans l'une des branches (3b) de la culasse magnétique (3) et que ladite languette (48) dépasse légèrement la platine (1).

EP 0 177 798 B1

# FIG. 1

# FIG. 2

1

FIG.3

FIG. 4

FIG. 5

FIG. 6